# EUROPEAN PATENT SPECIFICATION

(11) **EP 3 923 480 B1**
(45) Date of publication and mention of the grant of the patent: **22.04.2026**
(21) Application number: 20179626.5
(22) Date of filing: 12.06.2020
(51) Int. Cl.: H03L 7/02

(54) **CLOCKLESS TEMPERATURE SENSOR AND RESPECTIVE APPLICATION DEVICES AND METHOD**
TAKTLOSER TEMPERATURSENSOR UND ENTSPRECHENDE ANWENDUNGSVORRICHTUNGEN UND -VERFAHREN
CAPTEUR DE TEMPÉRATURE SANS HORLOGE ET DISPOSITIFS ET PROCÉDÉ D'APPLICATION RESPECTIFS

(43) Date of publication of application: 15.12.2021
(73) Proprietor: Stichting IMEC Nederland, 5656 AE Eindhoven (NL)
(72) Inventor: Ding, Ming, 3001 Leuven (BE)
(74) Representative: Körfer, Thomas

(56) References cited:
- WO-A1-2016/039688
- US-B2- 10 491 224
- SACCO ELISA ET AL: "A 16.1-b ENOB 0.064mm2 Compact Highly-Digital Closed-Loop Single-VCO-based 1-1 SMASH Resistance-to-Digital Converter in 180nm CMOS", 2019 IEEE ASIAN SOLID-STATE CIRCUITS CONFERENCE (A-SSCC), IEEE, 4 November 2019 (2019-11-04), pages 109 - 112, XP033753943, DOI: 10.1109/A-SSCC47793.2019.9056982
- KEN UENO ET AL: "Low-power temperature-to-frequency converter consisting of subthreshold CMOS circuits for integrated smart temperature sensors", SENSORS AND ACTUATORS A: PHYSICAL, vol. 165, no. 1, 30 March 2010 (2010-03-30), pages 132 - 137, XP028141399, ISSN: 0924-4247, [retrieved on 20100404], DOI: 10.1016/J.SNA.2010.03.030

## Description

The present invention relates to a temperature sensor, different application devices using this temperature sensor, and a method for measuring a temperature.

Especially in Internet of Things, IoT, applications, a very low power consumption of the respective devices is sought for. This is achieved by operating this type of mobile communication device using a duty cycle. This means that the respective device is only ready to communicate during certain time periods.

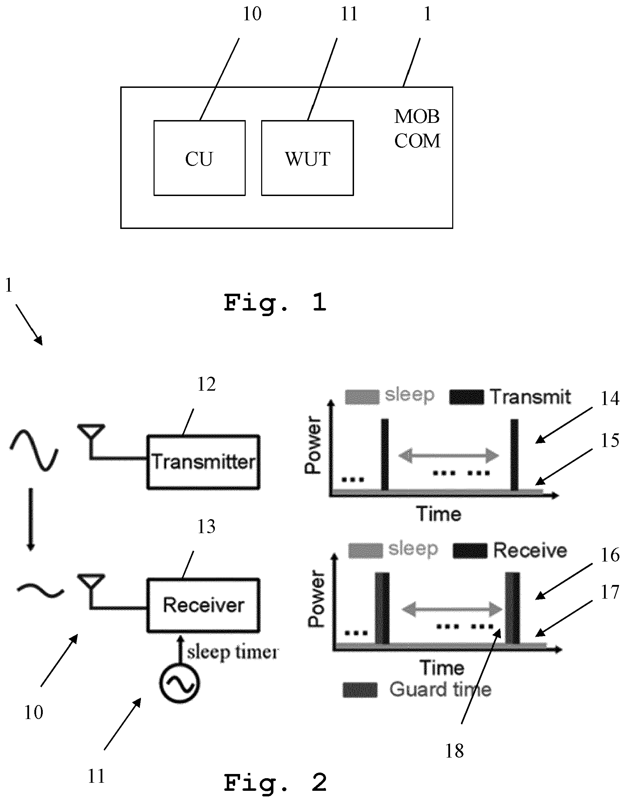

An exemplary device is shown in Fig. 1. The mobile communication device 1 comprises a communication unit 10 and a wake-up timer 11. During a listen operation mode, the communication unit 10 is active and receives messages. During a low-power operation mode, the communication unit 10 is deactivated and therefore not available for receiving messages.

In order to minimize the energy consumption of the mobile communication device 1, the listen operation mode, which consumes significantly more energy than the low-power operating mode, is only employed during brief, previously agreed upon periods.

This is achieved by using the wake-up timer 11, which determines when the mobile communication device 1 should enter the listen operating mode, and therefore when the communication unit 10 should be activated.

Since the mobile communication device 1 cannot receive a synchronization signal while the communication unit 1 is deactivated, the wake-up timer 11 needs to be a highly accurate clock. If the clock of the wake-up timer is of sub-optimal accuracy, a long guard interval needs to be added before the scheduled time of the listen operating mode, in order to compensate for clock deviations of the clock of the wake-up timer 11. This is shown in Fig. **2****.**

In Fig. 2, on the left side, details of an exemplary mobile communication device 1 are shown. The communication unit 10 and the wake-up timer 11 are also shown here. Especially, a transmitter 12 and a receiver 13 as part of the communication unit 10 are shown here. Moreover, the wake-up timer 11, here also referred to as "sleep timer", is shown.

In the top right part of Fig. 2, a timing diagram in a transmission case is shown. Reference number 15 indicates a constant power consumption independent of operating mode. Reference number 14 indicates additional power consumption during a transmission of messages when the communication unit 10 is active.

The lower right part of Fig. 2 shows a timing diagram for a reception case. Here, reference number 17 indicates a constant power consumption independent of operating mode. Reference number 16 indicates an additional power consumption while the communication device is in listen operating mode. Reference number 18 indicates an additional power consumption during a guard interval, which is added before the scheduled listen operating mode in order not to miss any messages intended for the mobile communication device 1 due to timing inaccuracies of the wake-up timer 11.

The longer the scheduled periods of the listen operating mode are apart, and the higher the inaccuracy of the clock of the wake-up timer 11, the longer the guard interval has to be chosen. Since the power consumption during the guard interval is similar to the power consumption during the listen operating mode, the use of such a guard interval significantly increases the overall energy consumption of the device.

The accuracy of a clock depends largely on the frequency accuracy of a resistor, which is part of the clock. The output frequency of such an oscillator though is temperature-dependent due to the temperature dependency of the resistor. Such a temperature dependency though may be compensated if the temperature dependency as well as the present temperature are known. Conventional temperature sensors though also have a high power consumption and/or require an accurate clock signal.

The document US 10,491,224 B2, for example, shows a wake-up timer having a high frequency accuracy. The temperature dependency of this wake-up timer though is not compensated completely.

The document Sacco Elisa et. al.: "A 16.1-b ENOB 0,064mm2 Compact Highly-Digital Closed-Loop Single-VCO-based 1-1 SMASH Resistance-to-Digital Converter in 180nm CMOS", 2019 IEEE ASIAN SOLID-STATE CIRCUITS CONFERENCE (A-SSCC), IEEE, 4 November 2019 (2019-11-04), pages 109-112, DOI: 10.1109/A-SSCC47793.2019.9056982 shows a clock-based temperature sensor, charging a capacitor through a single temperature-dependent resistor, and determining the temperature based upon the accumulated charge during a time-period measured by the clock.

An object of the present invention therefore is to provide a temperature sensor as well as a method for sensing temperature, which allow for a very low power consumption, while, at the same time, not requiring any pre-requisite timing signals.

The object is solved by the independent claims. Dependent claims contain further advantageous developments. In the following, parts of the description and drawings referring to embodiments that are not covered by the claims are not presented as embodiments of the invention, but as examples useful for understanding the invention.

An inventive temperature sensor serves the purpose of measuring a present temperature. The temperature sensor comprises a resistance switching loop, operating at a switching frequency, and a frequency locked loop, FLL, operating at an FLL frequency, higher than the switching frequency. The frequency-locked loop comprises a capacitor, which is configured to repeatedly be charged at the FLL frequency. Moreover, the frequency-locked loop comprises a charge comparator, configured to compare a charge level of the capacitor at a read-out time to a threshold, generating a charge comparison value, a charge level comparison integrator, configured to integrate the charge comparison value of successive cycles of the frequency-locked loop, outputting an integrated charge comparison value as a frequency-locked loop control signal. Moreover, the frequency-locked loop comprises a first resistor, having a negative temperature coefficient NTC, a second resistor, having a positive temperature coefficient TTC, and a switching unit.

Preferably the switching unit comprises a first switch, configured to switch, at a switching frequency, lower than the FLL frequency, between connecting a first supply voltage to the capacitor through the first resistor during an NTC charging period, and connecting the first supply voltage to the capacitor through the second resistor during a PTC charging period, wherein a ratio between the NTC charging period at the PTC charging period constitutes a switching duty cycle. The resistance switching loop comprises the switching unit and a duty cycle setting unit, configured to set the switching duty cycle based upon the integrated charge comparison value, wherein the switching duty cycle is a measure of the present temperature. This allows for determining the present temperature without requiring any external signals, and using only minimal power.

It should be mentioned that the resistors may be implemented as thermistors or a poly resistor, especially a CMOS poly resistor.

Preferably, the charge level comparison integrator is configured to output an integrated charge comparison value during the NTC charging period and an integrated charge comparison value during the PTC charging period. The duty cycle setting unit is configured to set the switching duty cycle based upon the integrated charge comparison value during the NTC charging period and the integrated charge comparison value during the PTC charging period. This allows for a very accurate determining of the present temperature.

Advantageously and preferably, the charge comparator is configured to output a positive charge comparison value, if the charge level of the capacitor is above the threshold, at a read-out time, and output a negative charge comparison value, if the charge level of the capacitor is below the threshold, at the read-out time. This allows for a very simple construction.

Preferably, the duty cycle setting unit comprises a temperature determiner, which is configured to determine the present temperature based upon a quotient of the integrated charge comparison value during the PTC charging period and the integrated charge comparison value during the NTC charging period. This allows for a very simple determining of the present temperature.

Advantageously and preferably, the duty cycle setting unit moreover comprises a duty cycle look-up-table, storing a plurality of present temperatures, and for each present temperature, a corresponding switching duty cycle value. The duty cycle setting unit is then configured to look up the corresponding switching duty cycle value to the present temperature provided by the temperature determiner in the look-up table, and set the switching duty cycle to the looked-up duty cycle. This allows for an especially simple control of the switching unit.

Preferably, the FLL moreover comprises a third resistor having a negative temperature coefficient, NTC, and a fourth resistor, having a positive temperature coefficient, PTC. The switching unit then comprises a second switch, configured to a switch, at the switching frequency, between connecting a second supply voltage to the capacitor through the third resistor during the NTC charging period and connecting the second supply voltage to the capacitor through the fourth resistor during the PTC charging period. By this symmetric construction, a further increase in accuracy can be achieved.

It might be noted that the first supply voltage can be applied to a first terminal of the capacitor through the first resistor/second resistor, while the second supply voltage can be supplied to a second terminal of the capacitor through the third/fourth resistor.

Advantageously and preferably, the first resistor and the third resistor are of similar, preferably identical type and value. Additionally or alternatively, the second resistor and the fourth resistor are of similar, preferably identical type and value. Additionally or alternatively, the first supply voltage is a positive supply voltage, preferably between 1 V and 10 V, more preferably between 3 V and 7 V, most preferably 5 V. Additionally or alternatively, the second supply voltage is ground voltage or a negative supply voltage, preferably between -1 V and -10 V, more preferably between -3 V and - 7 V, most preferably -5 V. This allows an especially simple construction.

Preferably, the switching unit moreover comprises a pulse-width modulator, which is configured to generate a pulse-width modulated switching signal based on the switching duty cycle determined by the duty cycle setting unit. Moreover, the pulse-width modulator is therein configured to control the first switch and/or the second switch using the pulse-width modulated switching signal. This allows for a very simple control of the switches.

Advantageously and preferably, the switching unit moreover comprises at least one reset switch. The reset switch is configured to discharge the capacitor after each cycle of the frequency-locked loop. This allows for an especially simple construction.

Preferably, the temperature sensor additionally comprises a controllable oscillator, and an oscillator controller, which is configured to receive the integrated charge comparison value from the charge level comparison integrator, and to generate an oscillator control signal, based upon the integrated charge comparison value . Moreover, the temperature compensator is configured to control the oscillator with the oscillator control signal, resulting in a preferably largely temperature-independent oscillator output signal, preferably setting the FLL frequency. This allows for an especially simple construction.

An inventive signal generator serves the purpose of generating a signal generator output signal. The signal generator comprises a previously described temperature sensor. The oscillator output signal therein is the signal generator output signal. The signal generator including the temperature sensor is preferably formed as a single integrated device on a microchip. This allows for an especially simple and low-power construction of a signal generator.

An inventive wakeup timer comprises a previously described signal generator and a counter. The counter is configured to count cycles of the signal generator output signal. The wakeup timer is configured to generate a wakeup signal, when the counter reaches a pre-determined number of counted cycles of the signal generator output signal. This allows for an especially accurate wakeup timer.

Preferably, the wakeup timer including the signal generator including the temperature sensor is formed as a single integrated device on a microchip. This allows for an especially simple and low-power construction of the wakeup timer.

An inventive mobile communication device comprises a previously described wakeup timer and a communication unit. The mobile communication device comprises a low-power operating mode, in which the communication unit is deactivated, and a listen operating mode, in which the communication unit is activated. The mobile communication device is configured to transition from the low-power operating mode to the listen operating mode when the wakeup timer generates the wakeup signal. This allows for an especially energy-efficient operation of the mobile communication device.

An inventive method serves the purpose of measuring a present temperature. The method comprises adapting a resistance of a first resistor, having a negative temperature coefficient, NTC, to the present temperature, adapting a resistance of a second resistor, having a positive temperature coefficient, PTC, to the present temperature, switching, at a switching frequency, between connecting a first supply voltage to a capacitor through the first resistor during an NTC charging period, and connecting the first supply voltage to the capacitor through the second resistor during a PTC charging period, wherein a ratio between the NTC charging period and the PTC charging period constitutes a switching duty cycle. The method moreover comprises repeatedly charging the capacitor in a frequency-locked loop, at an FLL frequency, higher than the switching frequency, comparing the charge level of the capacitor at a read-out time to a threshold, generating a charge comparison value. Moreover, the method comprises integrating the charge comparison value of successive cycles of the frequency-locked loop, outputting an integrated charge comparison value, as a frequency-locked loop control signal, and setting the switching duty cycle based upon the integrated charge comparison value, wherein the switching duty cycle is a measure of the present temperature. This allows for especially simple and low-power determining of the present temperature.

Exemplary embodiments of the invention are now further explained with regard to the drawings, in which
- Fig. 1: shows an exemplary mobile communication unit in a block diagram;
- Fig. 2: shows a further exemplary mobile communication unit and exemplary timing diagrams;
- Fig. 3: shows a first embodiment of the inventive temperature sensor;
- Fig. 4: shows a second, more detailed, embodiment of the inventive temperature sensor;
- Fig. 5: shows details of operation of a third embodiment of the inventive temperature sensor;
- Fig. 6: shows an embodiment of the inventive wake-up timer in a block diagram;
- Fig. 7: shows an embodiment of the inventive mobile communication device in a block diagram, and
- Fig. 8: shows an embodiment of the inventive method in a flow diagram.

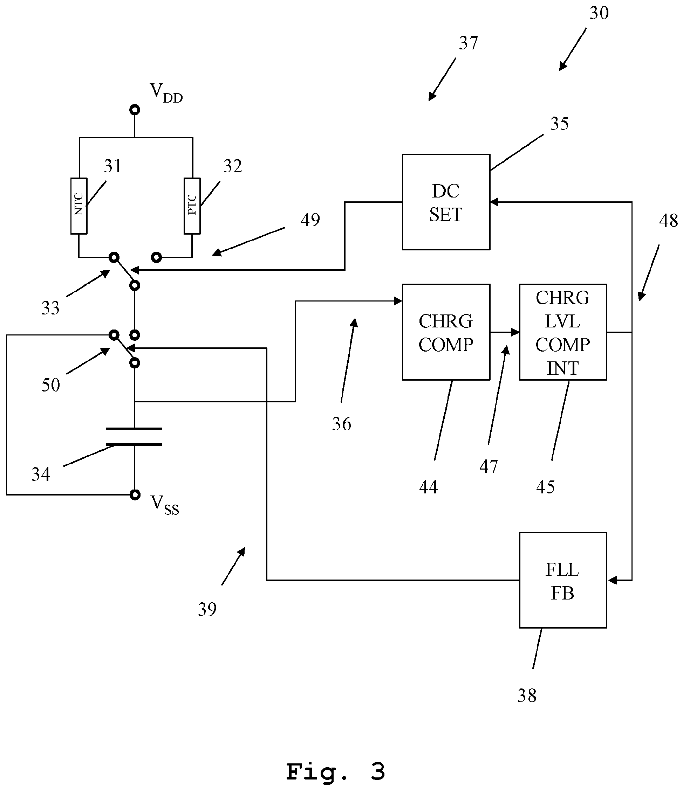

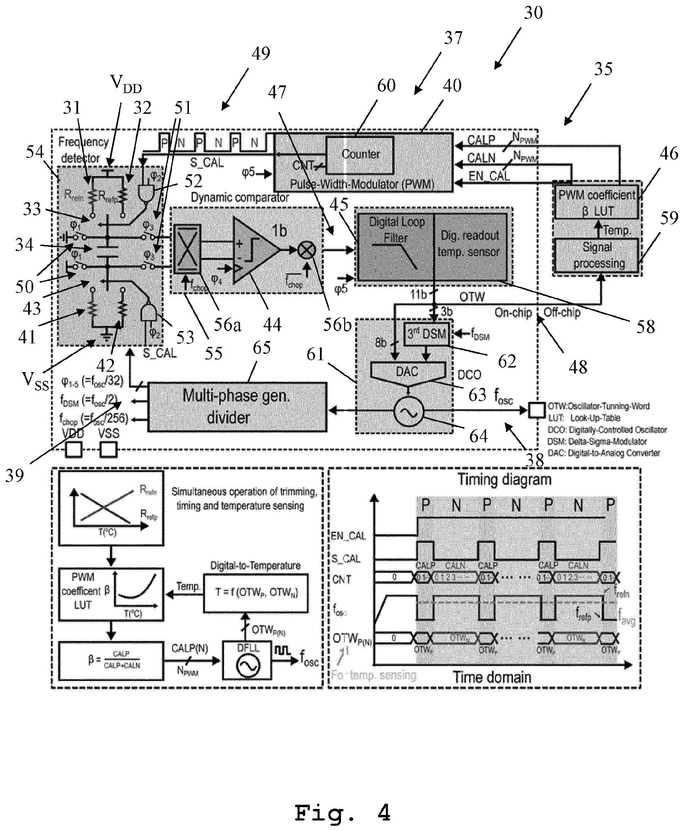

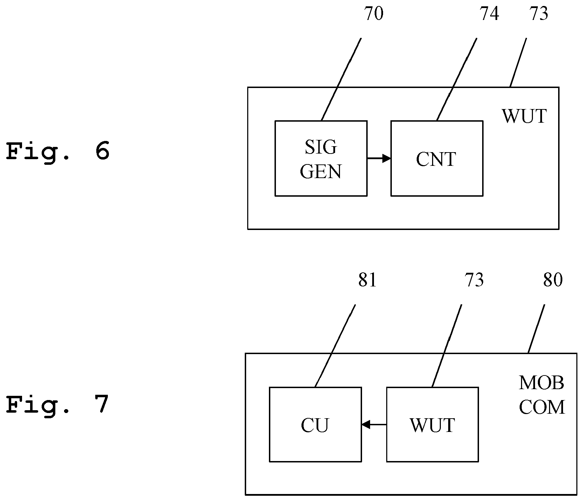

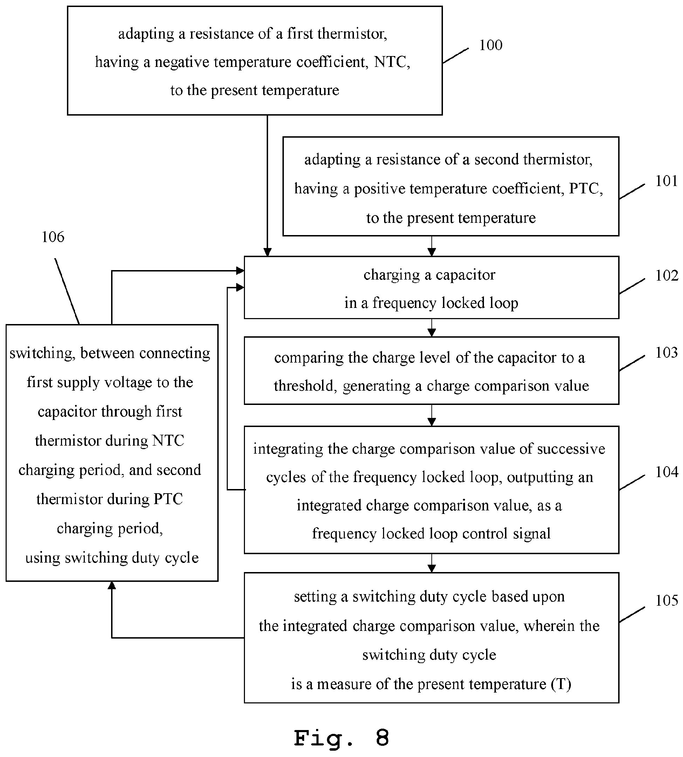

Along Fig. 1 and Fig. 2, in the previous introductory portion, the underlined problem is shown. With regard to Fig. 3, the basic construction and function of an embodiment of the inventive temperature sensor is shown. Along Fig. 4, a more elaborate embodiment of the inventive temperature sensor as well as it's function are described. Using Fig. 6 and Fig. 7, different applications of the inventive temperature sensor are shown and described. Finally, along Fig. 8, the function of an embodiment of the inventive method is shown in detail. Similar entities and reference numbers in different figures have been partially omitted.

In Fig. 3, a first embodiment of the inventive temperature sensor 30 is shown. A first resistor 31 is connected between a first supply voltage V_{DD} and a first switch 33. A second resistor 32 is also connected between the first supply voltage V_{DD} and the switch 33. The first resistor 31 and the second resistor 32 are therein connected to two different connections of the switch 33.

The first resistor 31 has a negative temperature coefficient (NTC). The second resistor 32 has a positive temperature coefficient (PTC). The switch 33 is connected to a reset switch 50, which is connected to a capacitor 34, in a first switch setting. The capacitor 34 is connected to a second supply voltage V_{SS} at it's other terminal. In a second switch setting, the capacitor 34 is connected to the second supply voltage V_{SS} at both terminals.

The first switch 33 as well as the reset switch 50 are part of a switching unit 49, not further shown here.

The first switch 33 is configured to switch a connection of the first supply voltage V_{DD} through either the first resistor 31 or through the second resistor 32 to the capacitor 34.

The temperature sensor 30 comprises a charge comparator 44, connected to the capacitor 34. The charge comparator 44 is moreover connected to a charge level comparison integrator 45, which in turn is connected to a frequency-locked loop feedback path 38. The frequency-locked loop feedback path 38 is connected to the reset switch 50.

Moreover, the temperature sensor 30 comprises a duty cycle setting unit 35, connected between the charge level comparison integrator 45 and the first switch 33.

The resistors 31, 32, the capacitor 34, the charge level comparator 44, the charge level comparison integrator 45, the switching unit 49, and the frequency locked loop feedback path 38 form a frequency locked loop 39.

The duty cycle setting unit 35 as well as the switching unit 49 form a resistance switching loop 37.

In operation, during a cycle of the frequency-locked loop 39, the capacitor 34 is charged either through the first resistor 31 or the second resistor 32. In the moment shown here, the capacitor 34 is charged through the first resistor 31. At a read-out time, which is a pre-determined amount of time after the begin of the cycle of the frequency-locked loop, a charge level 36 of the capacitor 34 is read out by the charge comparator 44, which compares the charge level of the capacitor 34 to a threshold. If the charge level of the capacitor is above the threshold, the charge comparator 44 outputs a positive charge comparison value 47. If the charge level of the capacitor 34 is below the threshold, the charge comparator 44 outputs a negative charge comparison value 47.

The charge comparison value 47 is integrated by the charge level comparison integrator 45 over consecutive cycles of the frequency-locked loop 39. A current integrated charge comparison value 48 is output to the frequency-locked loop feedback path 38, which comprises further components of the frequency-locked loop 39, not shown in detail here. For example, further components could be a controllable oscillator, adapted to generate an oscillator signal based upon the integrated charge comparison value 48, and to control the reset switch 50 based thereupon.

Moreover, the integrated charge comparison value 48 is used for controlling the first switch 33 of the switching unit 49 of the resistance setting loop 37. Especially, based upon the integrated charge comparison value 48, a switching duty cycle of the first switch 33 is determined. The switching duty cycle is defined as a ratio between an NTC charging period, during which the capacitor is charged through the first resistor 31 and a PTC charging period, during which the capacitor 34 is charged through the second resistor 32.

In Fig. 3, only the most basic components of the temperature sensor 30 relevant to the present invention are shown.

In the embodiments of Fig. 3 some components not essential for the invention have been omitted. For example, at least one, preferably two, additional reset switches might be connected to the terminals of the capacitor 34 so as to discharge the capacitor 34 after each cycle of the FLL 39. These switches would also be controlled by the switching unit 49. Also, in practice, a chopper might be inserted between the capacitor 34 and the charge comparator 44.

The first supply voltage V_{DD} is preferably between 1V and 10V, more preferably between 3V and 7V, most preferably 5V. In case of the asymmetric construction, as shown in Fig. 3, the second supply voltage V_{SS} is ground voltage.

Details of such further features are shown with regard to Fig. **4****.** In the top part of Fig. 4, a detailed construction of an embodiment of the inventive temperature sensor 30 is shown.

A frequency detector 54 comprises the first resistor 31, the second resistor 32, a third resistor 41 and a fourth resistor 42. Moreover, the first switch 33, the capacitor 34 and a second switch 43 are also comprised by the frequency detector 54. Furthermore, reset switches 50 are connected to the two terminals of the capacitor 34 and also belong to the frequency detector 54. Moreover, charge readout switches 51 are connected between the two terminals of the capacitor 34 and a dynamic comparator 55. The charge readout switches 51 are also part of the frequency detector 54. The frequency detector 54 moreover comprises AND gates 52, 53, which are connected to the first switch 33 and the second switch 43.

A dynamic comparator 55 comprises a chopper 56, which consists of a first partial chopper 56a and a second partial chopper 56b. The first partial chopper 56a is connected to the charge readout switches 51. The outputs of the first partial chopper 56a are connected to the charge comparator 44 introduced in Fig. 4. The output of the charge comparator 44 is connected to the second partial chopper 56b. The output of the second partial chopper 56b forms the output of the dynamic comparator 55 and are connected to the charge level comparison integrator 45, which is here formed by a digital loop filter. Since the digital loop filter has a low-pass characteristic, the function is identical to that of an integrator.

Connected to the charge level comparison integrator 45, is an output 58.

The temperature sensor 30 moreover comprises a temperature determiner 59, also referred to as signal processor 59, connected to the charge level comparison integrator 45. The signal processor 59 is connected to a duty cycle look-up-table 46. The duty cycle look-up-table 46 is connected to a pulse-width modulator 40, which comprises a counter 60.

Moreover, the output of the charge level comparison integrator 45 is connected to a controllable oscillator 61, especially a digitally controllable oscillator, DCO, which is comprised of a delta sigma modulator 62, a digital-analog converter 63, and a voltage controlled oscillator 64. Especially, the output of the charge level comparison integrator 45 is connected to the delta sigma modulator 62 and to the digital-analog converter 63. The delta sigma modulator 62 is also connected to the digital-analog converter 63. The digital-analog converter 63 is connected to the voltage controllable oscillator 64.

The delta sigma modulator 62 and the digital-analog converter 63 together form an oscillator controller, and generate an analog oscillator control signal, which is used to control the voltage controllable oscillator 64. Since this signal is generated based upon the output of the charge level comparison integrator 45, the voltage controlled oscillator 64 is controlled based upon the determined present temperature, which compensates this present temperature and generates a frequency-stable oscillator output signal.

The controllable oscillator 61 is connected to a multi-phase generator divider 65, which generates a plurality of control signals based upon the frequency-stable oscillator signal. Especially, the control signals for the exact timing of the different switches 33, 43, 50, 51 as well as the AND gates 52, 53 are generated, here.

The controllable oscillator 61 and the multi-phase generator divider 65 correspond to the frequency locked loop feedback path 38 of Fig. 3.

The switching unit 49, here comprises the switches 33, 43, 50, 51, the AND gates 52, 53, and the pulse width modulator 40.

The FLL 39 here comprises the frequency detector 54, the dynamic comparator 55, the digital loop filter 45, the signal processor 59, the duty cycle look-up-table 46, the pulse width modulator 40, the switching unit 49, and the resistors 31, 32, 41, 42.

The controllable oscillator 61 and the multi-phase generator divider 65 can be considered part of the temperature sensor 30, since the signals generated by the multi-phase generator divider 65 are used to control components of the temperature sensor 30. Also, the controlled oscillator 61 can be considered as the controlled oscillator of a signal generator.

The duty cycle setting unit 35, comprised by the signal processor 59, the look-up-table 46, as well as the switching unit 49 here form the resistance switching loop 37.

In case of the symmetric construction, as shown in Fig. 4, the second supply voltage V_{SS} is a negative voltage, preferably between -1V and -10V, more preferably between -3V and -7V, most preferably -5V.

In operation, at the beginning of a cycle of the frequency locked loop 39, the capacitor 34 is not charged or is charged to a pre-defined charge level by the reset switches 50. During an NTC charge period, the switches 33, 43 connect the first supply voltage V_{DD} through the first resistor 31 to the capacitor 34 and connect the second supply voltage V_{SS} through the third resistor 41 to the second terminal of the capacitor 34. During the NTC charge period, the capacitor 34 is charged at a speed defined by the resistance of the first resistor 31 and third resistor 41, which in turn is dependent upon the current temperature.

After a pre-determined amount of time, at a readout time, the readout switches 51 are activated based upon the signal φ₃ provided by the multi-phase generator divider 65. The readout switches 51 are closed, and the present charge of the capacitor 34 is handed on.

The first partial chopper 56a performs a chopping and hands on a chopped charge level signal to the charge comparator 44, which compares the charge level to a threshold. If the charge is larger than the threshold, a positive output value is handed on, while a negative output value is handed on if the charge is lower than the threshold. The charge comparator 44 therein operates when activated by the signal φ₄, which again is provided by the multi-phase generator divider 65.

The output signal of the charge comparator 44 is handed on to the second partial chopper 56b, which again removes the chopping effected by the first partial chopper 56a, resulting in a dynamic comparator output signal 47, which corresponds to the charge level comparison signal 47 of Fig. 3. This signal is handed on to the charge level comparison integrator 45, which performs an integration and provides an integrated charge level comparison signal 48, here also referred to as "oscillator tuning word, OTW".

Since at present, the capacitor 34 was charged through the first resistor 31 and the third resistor 41, an integrated charge level comparison signal during the NTC charging period OTWₙ is generated and provided by the charge level integrator 45.

The output signal of the charge level comparison integrator 45, the integrated charge level comparison signal 48, is handed on to the digitally controlled oscillator 61. Especially, it is handed on to the delta sigma modulator 62 and to the digital analog converter 63. An oscillator control signal for controlling the voltage controlled oscillator 64 is generated by the delta sigma modulator 62 and the digital analog converter 63. The voltage controlled oscillator 64 is controlled by this analog control signal.

This results in an output signal of the digitally controlled oscillator, which is handed on to the multi-phase generator divider 65, which divides this frequency and generates a plurality of signals for further use in the circuit. Especially, the FLL frequency of the frequency-locked loop 39 is generated here.

For a plurality of cycles of the frequency-locked loop 39, the first switch 33 and the second switch 43 connect the first resistor 31 and the third resistor 42, resulting in only the resistances of these resistors 41, 42 influencing the charging speed of the capacitor 34. After a number of cycles of the frequency-locked loop 39 determined by the duty cycle setting unit 35, the switches 33, 43 are controlled by the switching unit 49 to connect the second resistor 32 and the fourth resistor 42 instead of the first resistor 31 and the third resistor 41. Now, during a PTC charging period, the frequency-locked loop 39 operates for a number of cycles determined by the duty cycle setting unit 35. During each of these cycles, the capacitor 34 is charged through the second resistor 32 and fourth resistor 42. As described earlier, a charge level comparison by the charge comparator 44, optionally accompanied by a chopping by the chopper 56a, 56b is performed. After this, a charge comparison value 47 is handed on to the charge comparison integrator 45, which integrates the charge comparison value for successive cycles of the frequency-locked loop 39. Since now the capacitor 34 is charged through the second and fourth resistor 32, 42 the charge comparison integrator 45 outputs an integrated charge comparison value during the PTC charge period OTWₚ.

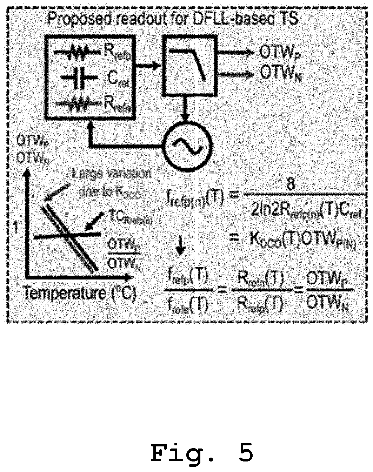

The present temperature cannot be determined from the integrated charge comparison value during the NTC charging period OTWₙ, or the integrated charge comparison value during the PTC charging period OTWₚ, alone. When both of these values are known though, the present temperature can be determined. Both values are handed on to the signal processor 59, also referred to as the temperature determiner 59, which calculates a quotient of the values, as shown in FIG. 5, and therefrom determines the present temperature. The present temperature is then handed on to the duty cycle look-up table 46, in which a plurality of present temperatures and an according switching duty cycle for each one of the present temperatures are stored. The duty cycle look-up table 46 then outputs a switching duty cycle corresponding to the present temperature determined by the temperature determiner 59. Especially, in this embodiment, the duty cycle look-up table 46 outputs the duty cycle in form of a first duty cycle signal CALP and a second duty cycle signal CALN. Additionally, an enable signal EN_CAL is output. The first duty cycle signal CALP indicates the number of cycles of the frequency-locked loop, during which the second resistor 32 and the fourth resistor 42 are used, while the second duty cycle signal CALN indicates the number of cycles of the frequency-locked loop, during which the first resistor 31 and the third resistor 41 are used. These signals are handed on to the pulse-width modulator 40, which generates a pulse-width modulated control signal S_CAL.

The switches 33, 43 are controlled by the AND gates 52, 53, which in turn are controlled by the pulse-width modulated output signal of the pulse-width modulator 40 and enable signals φ₂ provided by the multi-phase generator divider 65. During the indicated HIGH phases, labeled "P" in the pulse-width modulated output signal, the switches 33, 43 connect to the second resistor 32 and the fourth resistor 42, while in the LOW phases, labeled "N" in the pulse-width modulated output signal, of the pulse-width modulator 40, the switches 33, 43 connect to the first resistor 31 and the third resistor 41.

In the bottom left corner of Fig. 4, the principle function of the temperature sensor, and the oscillator tuning according to the present invention is shown. In the first diagram on the top left, the temperature dependency of the resistance of the first and third resistor as well as of the second and fourth resistor are shown. In the second diagram, the dependency of the coefficient β and the temperature is shown.

In the third diagram, the calculation of a factor β is shown as CALP/(CALP + CALN). The bottom left part of Fig. 4 further shows the feedback and control loop through the digital frequency-locked loop and the output of the frequency-stabilized oscillator signal.

In the bottom right corner, a timing diagram of the different signals shown in the top part of Fig. 4, is shown. The first curve shows the enable signal EN_CAL. The second cure shows the switch control signal S_CAL. The third curve shows the signals CALP and CALN. The fourth curve shows the output frequency of the oscillator, while the last curve shows the progression of the integrated charge comparison value OTW_{P} and OTW_{N}.

It should be pointed out that the oscillator output signal can be used as a signal generator output signal. Although the frequency of the signal generator output signal varies between two values, dependent upon the FLL 39 using the first resistor 31 and third resistor 41 or using the second resistor 32 and the fourth resistor 42, on average, the frequency of the signal generator output signal is temperature stabilized, since the switching duty cycle is set, so as to achieve this.

In FIG. 5, further details regarding the determining of the present temperature are shown. In the top part of the figure, a very generalized function principle showing the frequency detector, the charge level integrator and the oscillator, with the values of the resistors, of the capacitor, and of the output signals is shown. On the bottom left, the temperature-dependency of the values OTWₚ and OTWₙ and also the resulting temperature dependency of the quotient of OTWₚ and OTWₙ is shown. From this quotient, the present temperature is determined.

In the bottom right of FIG. 5, it is shown that the gain K_{DCO} of the oscillator cancels out and is therefore not relevant for determining the present temperature.

Therefore, when implementing the inventive temperature sensor 30, automatically a highly frequency stable signal generator is achieved.

In Fig. 6, an embodiment of an inventive wake-up timer 73 is shown. The inventive wake-up timer 73 here comprises a signal generator 70 as described before, and a counter 74. The signal generator 70 generates a frequency-stabilized output signal and provides it to the counter 74. The counter counts the periods of the frequency-stabilized signal provided by the signal generator 70, and generates a wake-up signal as soon as a specific number of counts is reached.

Moreover, in Fig. 7, an embodiment of the inventive mobile communication device 80 is shown. The mobile communication device 80 comprises a communication unit 81 as well as a wake-up timer 73, as shown in Fig. 6.

The mobile communication device 80 can operate in a listen operating mode, in which the communication unit 81 is activated, and in a low-power operating mode, in which the communication unit 81 is deactivated. During most of the time, the mobile communication device 80 operates in the low-power operating mode. Only when the wake-up timer 73 generates a wake-up signal, the mobile communication device 80 transitions to the listen operating mode, in which the communication unit 81 is activated, and the mobile communication device 80 listens for signals intended for it. Since the wake-up timer 73 can provide the wake-up signal very accurately at a specific time, it is not necessary to activate the communication unit significantly before a respectively scheduled time period for listening for messages. This significantly reduces the power consumption of the mobile communication device.

Finally, in Fig. 8, an embodiment of the inventive method is shown.

In a first step 100, a resistance of a first resistor having a negative temperature coefficient is adapted to the present temperature.

In a second step 101, a resistance of a second resistor having a positive temperature coefficient is adapted to the present temperature. It is important to note that the first step and the second step occur in parallel.

In a third step 102, a capacitor is charged as part of a frequency-locked loop.

In a fourth step 103, a charge level of the capacitor, at a read-out time, is compared to a threshold, generating a charge comparison value.

In a fifth step 104, the charge comparison value of successive cycles of the frequency-locked loop is integrated, outputting an integrated charge comparison value, as a frequency-locked loop control signal.

The steps 102-104 are repeated for a number of cycles of the frequency-locked loop depending upon a duty cycle determined in the sixth step 105.

In a sixth step 105, a switching duty cycle is set based upon the integrated charge comparison value. The switching duty cycle therein, is a measure of the present temperature.

In a seventh step 106, a switching between connecting a first supply voltage to the capacitor through a first resistor during an NTC charging period and connecting a second resistor during the PTC charging period, using the switching duty cycle determined in the sixth step 105, is performed. Therefore, it is alternated between a PTC charging period and an NTC charging period. During each of these charging periods, a number of cycles of the frequency-locked loop occur. The length of the PTC charging period and the NTC charging period is determined by the switching duty cycle.

It is important to note that all features of the temperature sensor, signal generator, wake-up timer and mobile communication device shown in Fig. 3 to Fig. 7 are also relevant to the inventive method described along Fig. 8 and are to be understood as explicitly disclosed also with regard to the method.

The invention is not limited to the examples and especially not to the use of the inventive temperature sensor in a signal generator or a wake-up timer or a mobile communication device. Also, other applications of the temperature sensor, of the signal generator and of the wake-up timer are possible and covered by the present invention. The characteristics of the exemplary embodiments moreover can be used in any advantageous combination.

## Claims

1. A temperature sensor (30) for measuring a present temperature (T), comprising
a resistance switching loop (37), operating at a switching frequency,
a frequency locked loop (39), FLL, operating at an FLL frequency, higher than the switching frequency, the FLL (39) comprising:
- a capacitor (34), configured to be repeatedly charged at the FLL frequency,
- a charge comparator (44), configured to compare a charge level (36) of the capacitor (34) at a readout time, to a threshold, generating a charge comparison value (47),
- a charge level comparison integrator (45), configured to integrate the charge comparison value (47) of successive cycles of the FLL, outputting an integrated charge comparison value (48), as an FLL control signal,
- a first resistor (31), having a negative temperature coefficient, NTC,
- a second resistor (32), having a positive temperature coefficient, PTC,
- a switching unit (49,
wherein the switching unit (49) comprises a first switch (33), configured to switch, at the switching frequency, between
- connecting a first supply voltage (VDD) to the capacitor (34) through the first resistor (31) during an NTC charging period, and
- connecting the first supply voltage (VDD) to the capacitor (34) through the second resistor (32) during a PTC charging period, wherein a ratio between the NTC charging period and the PTC charging period constitutes a switching duty cycle,
wherein the resistance switching loop (37) comprises the switching unit (49) and a duty cycle setting unit (35), configured to set the switching duty cycle based upon the integrated charge comparison value (48), wherein the switching duty cycle is a measure of the present temperature (T), and
wherein the FLL comprises
- a controllable oscillator (64),
- an oscillator controller (62, 63), configured
∘ to receive the integrated charge comparison value (48), from the charge level comparison integrator (45),
∘ to generate an oscillator control signal, based upon the integrated charge comparison value (48) , and
∘ to control the oscillator (64) with the oscillator control signal, resulting in a, preferably largely temperature independent, oscillator output signal, preferably setting the FLL frequency.

2. The temperature sensor (30) according to claim 1, wherein the charge level comparison integrator (45), is configured to
- output an integrated charge comparison value during the NTC charging period (OTWn), and
- output an integrated charge comparison value during the PTC charging period (OTWp),
wherein the duty cycle setting unit (35) is configured to set the switching duty cycle based upon the integrated charge comparison value during the NTC charging period (OTWn) and the integrated charge comparison value during the PTC charging period (OTWp).

3. The temperature sensor (30) according to any of claims 1 or 2,
wherein the charge comparator (44) is configured to
- output a positive charge comparison value (47), if the charge level of the capacitor (34) is above the threshold, at a readout time, and
- output a negative charge comparison value (47), if the charge level of the capacitor (34) is below the threshold, at the readout time.

4. The temperature sensor (30) according to any of the claims 1 to 3,
wherein the duty cycle setting unit (35) comprises a temperature determiner (59), configured to determine the present temperature (T) based upon a quotient of the integrated charge comparison value during the PTC charging period (OTWp) and the integrated charge comparison value during the NTC charging period (OTWn).

5. The temperature sensor (30) according to any of the claims 1 to 4,
wherein the duty cycle setting unit (35) comprises a duty cycle look-up-table (46), storing a plurality of present temperatures (T), and for each present temperature (T), a corresponding switching duty cycle value, and
wherein the duty cycle setting unit (35) is configured to
- look up the corresponding switching duty cycle value to the present temperature (T) provided by temperature determiner (59) in the look-up-table, and
- set the switching duty cycle to the looked up duty cycle.

6. The temperature sensor (30) according to any of the claims 1 to 5,
wherein the FLL (39) comprises
- a third resistor (41), having a negative temperature coefficient, NTC, and
- a fourth resistor (42), having a positive temperature coefficient, PTC,
wherein the switching unit (49) comprises a second switch (43), configured to switch, at the switching frequency, between
∘ connecting a second supply voltage (Vₛₛ) to the capacitor (34) through the third resistor during the NTC charging period, and
∘ connecting the second supply voltage (Vₛₛ) to the capacitor (34) through the fourth resistor during the PTC charging period.

7. The temperature sensor (30) according to claim 6,
wherein the first resistor (31) and the third resistor (41) are of similar, preferably identical type and value, and/or
wherein the second resistor (32) and the fourth resistor (42) are of similar, preferably identical type and value, and/or
wherein the first supply voltage (V_{DD}) is a positive supply voltage, preferably between 1V and 10V, more preferably between 3V and 7V, most preferably 5V, and/or
wherein the second supply voltage (Vₛₛ) is ground voltage, or a negative supply voltage, preferably between -1V and - 10V, more preferably between -3V and -7V, most preferably -5V.

8. The temperature sensor (30) according to any of the claims 1 to 7,
wherein the switching unit (49) comprises a pulse-width modulator (40), configured
- to generate a pulse-width modulated switching signal, based on the switching duty cycle determined by the duty cycle setting unit (35), and
- to control the first switch (33) and/or the second switch (43) using the pulse-width modulated switching signal.

9. The temperature sensor (30) according to any of the claims 1 to 8,
wherein the switching unit (49) comprises at least one reset switch (50), and
wherein the reset switch (50) is configured to discharge the capacitor (34) after each cycle of the frequency locked loop.

10. A signal generator, for generating a signal generator output signal, comprising a temperature sensor (30) according to any of the claims 1 to 9,
wherein the oscillator output signal is the signal generator output signal.

11. The signal generator according to claim 10,
wherein the signal generator including the temperature sensor is preferably formed as a single integrated device on a microchip.

12. A wake-up timer (73), comprising a signal generator (70) according to claim 10 or 11, and a counter (74),
wherein the counter (74) is configured to count cycles of the signal generator output signal,
wherein the wake-up timer (73) in configured to generate a wake-up signal, when the counter (74) reaches a pre-determined number of counted cycles of the signal generator output signal.

13. The wake-up timer (73) according to claim 12,
wherein the wake-up timer (73) including the signal generator including the temperature sensor (30) is formed as a single integrated device on a microchip.

14. A mobile communication device (80), comprising a wake-up timer (73) according to claim 12 or 13, and a communication unit (81),
wherein mobile communication device (80) comprises
- a low-power operating mode, in which the communication unit (81) is deactivated, and
- a listen operating mode, in which the communication unit (81) is activated,
wherein the mobile communication (80) device is configured to transition from the low-power operating mode to the listen operating mode when the wake-up timer (73) generates the wake-up-signal.

15. A method for measuring a present temperature (T), comprising:
- adapting (100) a resistance of a first resistor (31), having a negative temperature coefficient, NTC, to the present temperature,
- adapting (101) a resistance of a second resistor (32), having a positive temperature coefficient, PTC, to the present temperature,
- switching (106), at a switching frequency, between
∘ connecting a first supply voltage (VDD) to a capacitor (34) through the first resistor (31) during an NTC charging period, and
∘ connecting the first supply voltage (VDD) to the capacitor (34) through the second resistor (32) during a PTC charging period, wherein a ratio between the NTC charging period and the PTC charging period constitutes a switching duty cycle,
- repeatedly charging (102) the capacitor in a frequency locked loop, at an FLL frequency, higher than the switching frequency,
- comparing (103) the charge level of the capacitor (34) at a readout time, to a threshold, generating a charge comparison value (47),
- integrating (104) the charge comparison value (47) of successive cycles of the frequency locked loop, outputting an integrated charge comparison value (48), as a frequency locked loop control signal, and
- setting (105) the switching duty cycle based upon the integrated charge comparison value (48), wherein the switching duty cycle is a measure of the present temperature (T), and
wherein the FLL comprises
- a controllable oscillator (64),
- an oscillator controller (62, 63), configured
∘ to receive the integrated charge comparison value (48), from the charge level comparison integrator (45),
∘ to generate an oscillator control signal, based upon the integrated charge comparison value (48) , and
∘ to control the oscillator (64) with the oscillator control signal, resulting in **a,** preferably largely temperature independent, oscillator output signal, preferably setting the FLL frequency.

## Patentansprüche

1. Temperatursensor (30) zur Messung einer gegenwärtigen Temperatur (T), umfassend
eine Widerstandsschaltschleife (37), die mit einer Schaltfrequenz arbeitet,
eine Frequenzregelschleife (39), FLL (Frequency Locked Loop), die mit einer FLL-Frequenz arbeitet, die höher als die Schaltfrequenz ist, wobei die FLL (39) umfasst:
- einen Kondensator (34), der dazu ausgelegt ist, wiederholt mit der FLL-Frequenz geladen zu werden,
- einen Ladungskomparator (44), der dazu ausgelegt ist, ein Ladungsniveau (36) des Kondensators (34) bei einer Auslesezeit mit einem Schwellenwert zu vergleichen, wodurch ein Ladungsvergleichswert (47) erzeugt wird;
- einen Ladungsniveau-Vergleichsintegrator (45), der dazu ausgelegt ist, den Ladungsvergleichswert (47) aufeinanderfolgender Zyklen der FLL zu integrieren und einen integrierten Ladungsvergleichswert (48) als FLL-Steuersignal auszugeben;
- einen ersten Widerstand (31) mit negativem Temperaturkoeffizienten NTC (Negative Temperature Coefficient),
- einen zweiten Widerstand (32) mit positivem Temperaturkoeffizienten PTC (Positive Temperature Coefficient),
- einer Schalteinheit (49),
wobei die Schalteinheit (49) einen ersten Schalter (33) aufweist, der dazu ausgelegt ist, bei der Schaltfrequenz umzuschalten zwischen
- Verbinden einer ersten Versorgungsspannung (VDD) mit dem Kondensator (34) über den ersten Widerstand (31) während einer NTC-Ladeperiode und
- Verbinden der ersten Versorgungsspannung (VDD) mit dem Kondensator (34) über den zweiten Widerstand (32) während einer PTC-Ladeperiode, wobei ein Verhältnis zwischen der NTC-Ladeperiode und der PTC-Ladeperiode ein Schalttastverhältnis darstellt;
wobei die Widerstandsschaltschleife (37) die Schalteinheit (49) und eine Tastverhältnis-Einstelleinheit (35) umfasst, die dazu ausgelegt ist, das Schalttastverhältnis basierend auf dem integrierten Ladungsvergleichswert (48) einzustellen, wobei das Schalttastverhältnis ein Maß für die gegenwärtige Temperatur (T) ist und
wobei die FLL umfasst
- einen steuerbaren Oszillator (64),
- einen Oszillator (62, 63), der dazu ausgelegt ist,
∘ den integrierten Ladungsvergleichswert (48) vom Ladungsniveau-Vergleichsintegrator (45) zu erhalten,
∘ ein Oszillator-Steuersignal zu erkennen, basierend auf dem integrierten Ladungsvergleichswert (48), und
∘ den Oszillator (64) mit dem Oszillator-Steuersignal zu steuern, was zu einem vorzugsweise weitgehend temperaturunabhängigen Oszillator-Ausgangssignal führt, vorzugsweise zur Einstellung der FLL-Frequenz.

2. Temperatursensor (30) nach Anspruch 1,
wobei der Ladungsniveau-Vergleichsintegrator (45) dazu ausgelegt ist,
- einen integrierten Ladungsvergleichswert während der NTC-Ladeperiode (OTWn) auszugeben und
- einen integrierten Ladungsvergleichswert während der PTC-Ladeperiode (OTWp) ausgeben,
wobei die Tastverhältnis-Einstelleinheit (35) dazu ausgelegt ist, das Schalttastverhältnis basierend auf dem integrierten Ladungsvergleichswert während der NTC-Ladeperiode (OTWn) und dem integrierten Ladungsvergleichswert während der PTC-Ladeperiode (OTWp) einzustellen.

3. Temperatursensor (30) nach einem der Ansprüche 1 oder 2,
wobei der Ladungskomparator (44) dazu ausgelegt ist,
- einen positiven Ladungsvergleichswert (47) auszugeben, wenn das Ladungsniveau des Kondensators (34) bei einer Auslesezeit über dem Schwellenwert liegt, und
- einen negativen Ladungsvergleichswert (47) auszugeben, wenn das Ladungsniveau des Kondensators (34) bei der Auslesezeit unter dem Schwellenwert liegt.

4. Temperatursensor (30) nach einem der Ansprüche 1 bis 3,
wobei die Tastverhältnis-Einstelleinheit (35) einen Temperaturbestimmer (59) umfasst, der dazu ausgelegt ist, die gegenwärtige Temperatur (T) zu bestimmen, basierend auf einem Quotienten aus dem integrierten Ladungsvergleichswert während der PTC-Ladeperiode (OTWp) und dem integrierten Ladungsvergleichswert während der NTC-Ladeperiode (OTWn).

5. Temperatursensor (30) nach einem der Ansprüche 1 bis 4,
wobei die Tastverhältnis-Einstelleinheit (35) eine Tastverhältnis-Nachschlagetabelle (46) umfasst, in der mehrere gegenwärtige Temperaturen (T) und für jede gegenwärtige Temperatur (T) ein entsprechender Schalttastverhältniswert gespeichert sind, und
wobei die Tastverhältnis-Einstelleinheit (35) dazu ausgelegt ist,
- den entsprechenden Schalttastverhältniswert zu der gegenwärtigen Temperatur (T), die vom Temperaturbestimmer (59) bereitgestellt wird, in der Nachschlagetabelle nachzuschlagen, und
- das Tastverhältnis auf das nachgeschlagene Tastverhältnis einzustellen.

6. Temperatursensor (30) nach einem der Ansprüche 1 bis 5,
wobei die FLL (39) umfasst
- einen dritten Widerstand (41) mit negativem Temperaturkoeffizienten, NTC, und
- einen vierten Widerstand (42) mit positivem Temperaturkoeffizienten, PTC, wobei die Schalteinheit (49) einen zweiten Schalter (43) aufweist, der dazu ausgelegt ist, bei der Schaltfrequenz umzuschalten zwischen
- Verbinden einer zweiten Versorgungsspannung (Vₛₛ) mit dem Kondensator (34) über den dritten Widerstand während der NTC-Ladeperiode und
- Verbinden der zweiten Versorgungsspannung (Vₛₛ) mit dem Kondensator (34) über den vierten Widerstand während der PTC-Ladeperiode.

7. Temperatursensor (30) nach Anspruch 6,
wobei der erste Widerstand (31) und der dritte Widerstand (41) von ähnlichem, vorzugsweise identischem Typ und Wert sind und/oder
wobei der zweite Widerstand (32) und der vierte Widerstand (42) von ähnlichem, vorzugsweise identischem Typ und Wert sind und/oder
wobei die erste Versorgungsspannung (V_{DD}) eine positive Versorgungsspannung ist, vorzugsweise zwischen 1 V und 10 V, besonders bevorzugt zwischen 3 V und 7 V, am meisten bevorzugt 5 V, und/oder
wobei die zweite Versorgungsspannung (Vₛₛ) eine Massespannung oder eine negative Versorgungsspannung ist, vorzugsweise zwischen -1 V und -10 V, besonders bevorzugt zwischen -3 V und -7 V, am meisten bevorzugt -5 V.

8. Temperatursensor (30) nach einem der Ansprüche 1 bis 7,
wobei die Schalteinheit (49) einen Pulsbreitenmodulator (40) umfasst, der dazu ausgelegt ist,
- ein pulsbreitenmoduliertes Schaltsignal zu erzeugen, basierend auf dem von der Tastverhältnis-Einstellungseinheit (35) bestimmten Tastverhältnis, und
- den ersten Schalter (33) und/oder den zweiten Schalter (43) mit dem pulsbreitenmodulierten Schaltsignal zu steuern.

9. Temperatursensor (30) nach einem der Ansprüche 1 bis 8,
wobei die Schalteinheit (49) mindestens einen Rückstellschalter (50) umfasst und wobei der Rückstellschalter (50) dazu ausgelegt ist, den Kondensator (34) nach jedem Zyklus der Frequenzregelschleife zu entladen.

10. Signalgenerator zum Erzeugen eines Signalgenerator-Ausgangssignals, umfassend einen Temperatursensor (30) nach einem der Ansprüche 1 bis 9, wobei das Oszillator-Ausgangssignal das Ausgangssignal des Signalgenerators ist.

11. Signalgenerator nach Anspruch 10,
wobei der Signalgenerator, der den Temperatursensor aufweist, vorzugsweise als einzelne integrierte Vorrichtung auf einem Mikrochip ausgebildet ist.

12. Weckzeitgeber (73), umfassend einen Signalgenerator (70) nach Anspruch 10 oder 11 und einen Zähler (74),
wobei der Zähler (74) dazu ausgelegt ist, Zyklen des Signalgenerator-Ausgangssignals zu zählen,
wobei der Weckzeitgeber (73) dazu ausgelegt ist, ein Wecksignal zu erzeugen, wenn der Zähler (74) eine vorbestimmte Anzahl von gezählten Zyklen des Signalgenerator-Ausgangssignals erreicht.

13. Weckzeitgeber (73) nach Anspruch 12,
wobei der Weckzeitgeber (73), der den Signalgenerator aufweist, der den Temperatursensor (30) aufweist, als einzelne integrierte Vorrichtung auf einem Mikrochip ausgebildet ist.

14. Mobilkommunikationsvorrichtung (80), umfassend einen Weckzeitgeber (73) nach Anspruch 12 oder 13 und eine Kommunikationseinheit (81),
wobei die Mobilkommunikationsvorrichtung (80) umfasst
- einen Niedrigenergie-Betriebsmodus, in dem die Kommunikationseinheit (81) deaktiviert ist, und
- einen Hören-Betriebsmodus, in dem die Kommunikationseinheit (81) aktiviert ist,
wobei die Mobilkommunikationsvorrichtung (80) dazu ausgelegt ist, vom Niedrigenergie-Betriebsmodus in den Hören-Betriebsmodus überzugehen, wenn der Weckzeitgeber (73) das Wecksignal erzeugt.

15. Verfahren zur Messung einer gegenwärtigen Temperatur (T), umfassend:
- Anpassen (100) des Widerstandswerts eines ersten Widerstands (31) mit negativem Temperaturkoeffizienten, NTC, an die gegenwärtige Temperatur,
- Anpassen (101) eines Widerstandswerts eines zweiten Widerstands (32) mit positivem Temperaturkoeffizienten, PTC, an die gegenwärtige Temperatur,
- Umschalten (106), bei einer Schaltfrequenz, zwischen
∘ Verbinden einer ersten Versorgungsspannung (VDD) mit einem Kondensator (34) über den ersten Widerstand (31) während einer NTC-Ladeperiode und
∘ Verbinden der ersten Versorgungsspannung (VDD) mit dem Kondensator (34) über den zweiten Widerstand (32) während einer PTC-Ladeperiode, wobei ein Verhältnis zwischen der NTC-Ladeperiode und der PTC-Ladeperiode ein Schalttastverhältnis darstellt;
- wiederholtes Aufladen (102) des Kondensators in einer Frequenzregelschleife mit einer FLL-Frequenz, die höher als die Schaltfrequenz ist,
- Vergleichen (103) des Ladungsniveaus des Kondensators (34) bei einer Auslesezeit mit einem Schwellenwert, wodurch ein Ladungsvergleichswert (47) erzeugt wird,
- Integrieren (104) des Ladungsvergleichswerts (47) aufeinanderfolgender Zyklen der Frequenzregelschleife, wobei ein integrierter Ladungsvergleichswert (48) ausgegeben wird, als Steuersignal der Frequenzregelschleife, und
- Einstellen (105) des Schalt-Tastverhältnisses basierend auf dem integrierten Ladungsvergleichswert (48), wobei das Tastverhältnis ein Maß für die gegenwärtige Temperatur (T) ist, und
wobei die FLL umfasst
- einen steuerbaren Oszillator (64),
- einen Oszillator (62, 63), der dazu ausgelegt ist,
∘ den integrierten Ladungsvergleichswert (48) vom Ladungsniveau-Vergleichsintegrator (45) zu erhalten,
∘ ein Oszillator-Steuersignal zu erkennen, basierend auf dem integrierten Ladungsvergleichswert (48), und
∘ den Oszillator (64) mit dem Oszillator-Steuersignal zu steuern, was zu einem vorzugsweise weitgehend temperaturunabhängigen Oszillator-Ausgangssignal führt, vorzugsweise zur Einstellung der FLL-Frequenz.

## Revendications

1. Capteur de température (30) pour mesurer une température actuelle (T), comprenant
une boucle de commutation de résistance (37), fonctionnant à une fréquence de commutation,
une boucle à verrouillage de fréquence (39), FLL, fonctionnant à une fréquence FLL, supérieure à la fréquence de commutation, la FLL (39) comprenant :
- un condensateur (34), configuré pour être chargé de manière répétée à la fréquence FLL,
- un comparateur de charge (44), configuré pour comparer un niveau de charge (36) du condensateur (34) à un instant de lecture, à un seuil, générant une valeur de comparaison de charge (47),
- un intégrateur de comparaison de niveau de charge (45), configuré pour intégrer la valeur de comparaison de charge (47) de cycles successifs de la FLL, produisant une valeur de comparaison de charge intégrée (48), sous forme de signal de commande de FLL,
- une première résistance (31), présentant un coefficient de température négatif, CTN,
- une deuxième résistance (32), présentant un coefficient de température positif, CTP,
- une unité de commutation (49),
dans lequel l'unité de commutation (49) comprend un premier commutateur (33), configuré pour commuter, à la fréquence de commutation, entre
- la connexion d'une première tension d'alimentation (VDD) au condensateur (34) par l'intermédiaire de la première résistance (31) pendant une période de charge CTN, et
- la connexion de la première tension d'alimentation (VDD) au condensateur (34) par l'intermédiaire de la deuxième résistance (32) pendant une période de charge CTP, un rapport entre la période de charge CTN et la période de charge CTP constituant un rapport cyclique de commutation,
dans lequel la boucle de commutation de résistance (37) comprend l'unité de commutation (49) et une unité de réglage de rapport cyclique (35), configurée pour régler le rapport cyclique de commutation sur la base de la valeur de comparaison de charge intégrée (48), le rapport cyclique de commutation étant une mesure de la température actuelle (T), et
dans lequel la FLL comprend
- un oscillateur commandable (64),
- un contrôleur d'oscillateur (62, 63), configuré
∘ pour recevoir la valeur de comparaison de charge intégrée (48), en provenance de l'intégrateur de comparaison de niveau de charge (45),
∘ pour générer un signal de commande d'oscillateur, basé sur la valeur de comparaison de charge intégrée (48), et
∘ pour commander l'oscillateur (64) au moyen du signal de commande d'oscillateur, cela conduisant à un signal de sortie d'oscillateur, de préférence largement indépendant de la température, et de régler de manière préférable la fréquence FLL.

2. Capteur de température (30) selon la revendication 1,
dans lequel l'intégrateur de comparaison de niveau de charge (45) est configuré pour
- fournir en sortie une valeur de comparaison de charge intégrée pendant la période de charge CTN (OTWn), et
- fournir en sortie une valeur de comparaison de charge intégrée pendant la période de charge CTP (OTWp),
dans lequel l'unité de réglage de rapport cyclique (35) est configurée pour régler le rapport cyclique de commutation sur la base de la valeur de comparaison de charge intégrée pendant la période de charge CTN (OTWn) et de la valeur de comparaison de charge intégrée pendant la période de charge CTP (OTWp).

3. Capteur de température (30) selon l'une quelconque des revendications 1 ou 2,
dans lequel le comparateur de charge (44) est configuré pour
- fournir en sortie une valeur de comparaison de charge positive (47), si le niveau de charge du condensateur (34) est supérieur au seuil, à un instant de lecture, et
- fournir en sortie une valeur de comparaison de charge négative (47), si le niveau de charge du condensateur (34) est inférieur au seuil, à l'instant de lecture.

4. Capteur de température (30) selon l'une quelconque des revendications 1 à 3,
dans lequel l'unité de réglage de rapport cyclique (35) comprend un dispositif de détermination de température (59), configuré pour déterminer la température actuelle (T) sur la base d'un quotient de la valeur de comparaison de charge intégrée pendant la période de charge CTP (OTWp) et de la valeur de comparaison de charge intégrée pendant la période de charge CTN (OTWn).

5. Capteur de température (30) selon l'une quelconque des revendications 1 à 4,
dans lequel l'unité de réglage de rapport cyclique (35) comprend une table de consultation de rapport cyclique (46), stockant une pluralité de températures actuelles (T), et pour chaque température actuelle (T), une valeur de rapport cyclique de commutation correspondante, et
dans lequel l'unité de réglage de rapport cyclique (35) est configurée pour
- consulter la valeur de rapport cyclique de commutation correspondante à la température actuelle (T) fournie par le dispositif de détermination de température (59) dans la table de consultation, et
- régler le rapport cyclique de commutation à la valeur du rapport cyclique consulté.

6. Capteur de température (30) selon l'une quelconque des revendications 1 à 5,
dans lequel la FLL (39) comprend
- une troisième résistance (41), présentant un coefficient de température négatif, CTN, et
- une quatrième résistance (42), présentant un coefficient de température positif, CTP,
dans lequel l'unité de commutation (49) comprend un deuxième commutateur (43), configuré pour commuter, à la fréquence de commutation, entre
∘ la connexion d'une deuxième tension d'alimentation (Vₛₛ) au condensateur (34) par l'intermédiaire de la troisième résistance pendant la période de charge CTN, et
∘ la connexion de la deuxième tension d'alimentation (V_{SS}) au condensateur (34) par l'intermédiaire de la quatrième résistance pendant la période de charge CTP.

7. Capteur de température (30) selon la revendication 6,
dans lequel la première résistance (31) et la troisième résistance (41) sont de type et de valeur similaires, de préférence identiques, et/ou
la deuxième résistance (32) et la quatrième résistance (42) sont de type et de valeur similaires, de préférence identiques, et/ou
dans lequel la première tension d'alimentation (V_{DD}) est une tension d'alimentation positive, de préférence comprise entre 1V et 10V, plus préférablement entre 3V et 7V, et le plus préférablement de 5V, et/ou
dans lequel la deuxième tension d'alimentation (V_{SS}) est une tension de masse, ou une tension d'alimentation négative, de préférence comprise entre -1V et -10V, plus préférablement entre -3V et -7V, et le plus préférablement de -5V.

8. Capteur de température (30) selon l'une quelconque des revendications 1 à 7,
dans lequel l'unité de commutation (49) comprend un modulateur de largeur d'impulsion (40), configuré
- pour générer un signal de commutation modulé en largeur d'impulsion, sur la base du rapport cyclique de commutation déterminé par l'unité de réglage de rapport cyclique (35), et
- pour commander le premier commutateur (33) et/ou le deuxième commutateur (43) à l'aide du signal de commutation modulé en largeur d'impulsion.

9. Capteur de température (30) selon l'une quelconque des revendications 1 à 8,
dans lequel l'unité de commutation (49) comprend au moins un commutateur de réinitialisation (50), et
dans lequel le commutateur de réinitialisation (50) est configuré pour décharger le condensateur (34) après chaque cycle de la boucle à verrouillage de fréquence.

10. Générateur de signal, destiné à générer un signal de sortie de générateur de signal, comprenant un capteur de température (30) selon l'une quelconque des revendications 1 à 9,
dans lequel le signal de sortie d'oscillateur est le signal de sortie du générateur de signal.

11. Générateur de signal selon la revendication 10,
dans lequel le générateur de signal comportant le capteur de température est de préférence réalisé sous la forme d'un dispositif intégré unique sur une micropuce.

12. Temporisateur de réveil (73), comprenant un générateur de signal (70) selon la revendication 10 ou 11, et un compteur (74),
dans lequel le compteur (74) est configuré pour compter des cycles du signal de sortie du générateur de signal,
dans lequel le temporisateur de réveil (73) est configuré pour générer un signal de réveil, lorsque le compteur (74) atteint un nombre prédéterminé de cycles comptés du signal de sortie du générateur de signal.

13. Temporisateur de réveil (73) selon la revendication 12,
dans lequel le temporisateur de réveil (73) comportant le générateur de signal comportant le capteur de température (30) est réalisé sous la forme d'un dispositif intégré unique sur une micropuce.

14. Dispositif de communication mobile (80), comprenant un temporisateur de réveil (73) selon la revendication 12 ou 13, et une unité de communication (81), dans lequel le dispositif de communication mobile (80) comprend
- un mode de fonctionnement à faible puissance, dans lequel l'unité de communication (81) est désactivée, et
- un mode de fonctionnement en écoute, dans lequel l'unité de communication (81) est activée,
dans lequel le dispositif de communication mobile (80) est configuré pour passer du mode de fonctionnement à faible puissance au mode de fonctionnement en écoute lorsque le temporisateur de réveil (73) génère le signal de réveil.

15. Procédé de mesure d'une température actuelle (T), comprenant :
- l'adaptation (100) d'une valeur d'une première résistance (31), présentant un coefficient de température négatif, CTN, à la température actuelle,
- l'adaptation (101) d'une valeur d'une deuxième résistance (32) présentant un coefficient de température positif, CTP, à la température actuelle,
- la commutation (106), à une fréquence de commutation, entre
∘ la connexion d'une première tension d'alimentation (VDD) à un condensateur (34) par l'intermédiaire de la première résistance (31) pendant une période de charge CTN, et
∘ la connexion de la première tension d'alimentation (VDD) au condensateur (34) par l'intermédiaire de la deuxième résistance (32) pendant une période de charge CTP, un rapport entre la période de charge CTN et la période de charge CTP constituant un rapport cyclique de commutation,
- la charge répétée (102) du condensateur dans une boucle à verrouillage de fréquence, à une fréquence FLL, supérieure à la fréquence de commutation,
- la comparaison (103) du niveau de charge du condensateur (34) à un instant de lecture, à un seuil, générant une valeur de comparaison de charge (47),
- l'intégration (104) de la valeur de comparaison de charge (47) de cycles successifs de la boucle à verrouillage de fréquence, fournissant en sortie une valeur de comparaison de charge intégrée (48), en tant que signal de commande de boucle à verrouillage de fréquence, et
- le réglage (105) du rapport cyclique de commutation sur la base de la valeur de comparaison de charge intégrée (48), le rapport cyclique de commutation étant une mesure de la température actuelle (T), et
dans lequel la FLL comprend
- un oscillateur commandable (64),
- un contrôleur d'oscillateur (62, 63), configuré
∘ pour recevoir la valeur de comparaison de charge intégrée (48), en provenance de l'intégrateur de comparaison de niveau de charge (45),
∘ pour générer un signal de commande d'oscillateur, basé sur la valeur de comparaison de charge intégrée (48), et
∘ pour commander l'oscillateur (64) au moyen du signal de commande d'oscillateur, cela conduisant à un signal de sortie d'oscillateur, de préférence largement indépendant de la température, et de régler de manière préférable la fréquence FLL.
